# EUROPEAN PATENT APPLICATION

(11) **EP 3 032 663 A1**
(43) Date of publication of application: **15.06.2016**
(21) Application number: 13891007.0
(22) Date of filing: 06.08.2013
(51) Int. Cl.: H02B 1/00

(54) **POWER CABINET FOR MEDIUM-HIGH VOLTAGE INVERTERS**

(71) Applicant: ABB Technology Ltd., 8050 Zürich (CH)
(72) Inventor: VOEGELI, Andreas, Beijing 100015 (CN); GERBER, Daniel, Beijing 100015 (CN); LUO, Shen, Beijing 100123 (CN)
(74) Representative: Zimmermann & Partner Patentanwälte mbB
(86) International application number: PCT/CN2013/080902
(87) International publication number: WO 2015/017976

(57) **Abstract**

A power cabinet (100) for medium-high voltage converter. The power cabinet (100) comprises a cabinet housing (110) and a rack (120) for mounting power modules (210, 220, 230), wherein the rack (120) comprises at least one pair of upright beams (121) and sliding rails (123) arranged on the paired upright beams (121), at least one column of space for accommodating the power modules (210, 220, 230) is formed by the at least one pair of upright beams (121), and the sliding rails (123) are used for supporting the power modules (210, 220, 230).

## Description

### FIELD OF INVENTION

The present application relates to a power cabinet for converter, more specifically, to a power cabinet for MV/HV converter.

### BACKGROUND OF INVENTION

MV/HV converter is usually rather big and includes transformer cabinet, inverter cabinet and control cabinet etc. The inverter cabinet, especially those for MV/HV converter, is very big and space consuming because of its high power level and big amount of power modules therein. Current structure of power cabinet cannot meet specific requirements as size of power module is decreasing and cable layout is changing, a new power cabinet is therefore needed.

### SUMMARY OF INVENTION

The present application proposes a power cabinet for MV/HV converter, characterized in that, the power cabinet including a cabinet housing and a rack for mounting power modules, the rack including at least a pair of upright beams and sliding rails arranged on the paired upright beams, the at least a pair of upright beams form at least a column of space for accommodating power modules, and the sliding rails are used for supporting the power modules.

In an embodiment, the rack further includes a plurality of horizontal beams arranged in the width direction of the power cabinet.

In an embodiment the plurality of horizontal beams are arranged with one or three power modules therebetween.

In an embodiment a cable tray is arranged on the horizontal beams.

In an embodiment, the rack is divided into three rows by the horizontal beams.

In an embodiment, the power cabinet is provided with a control distributor.

In an embodiment, cables used for power modules with same phase becomes longer from front to back of the cabinet.

In an embodiment, a cooling fan is provided on the top of the housing.

In an embodiment, a stopper is provided at rear end of the sliding rail.

The present structure can reduce the size of converter, and miniaturize and compact the converter.

### BRIEF DESCRIPTION OF THE DRAWINGS

Fig. 1 shows an overall view of a power cabinet according to one embodiment of present application;
Fig. 2 shows a partially enlarged view of a power cabinet according to one embodiment of present application;
Fig. 3 shows another partially enlarged view of a power cabinet according to one embodiment of present application;
Fig. 4 shows a partial top view of a power cabinet according to one embodiment of present application; and
Fig. 5 shows a partially enlarged side view of a power cabinet according to one embodiment of present application.

### DETAILED DESCRIPTION OF EMBODIMENTS

Detailed description of embodiments of present application is given below with reference to the drawings.

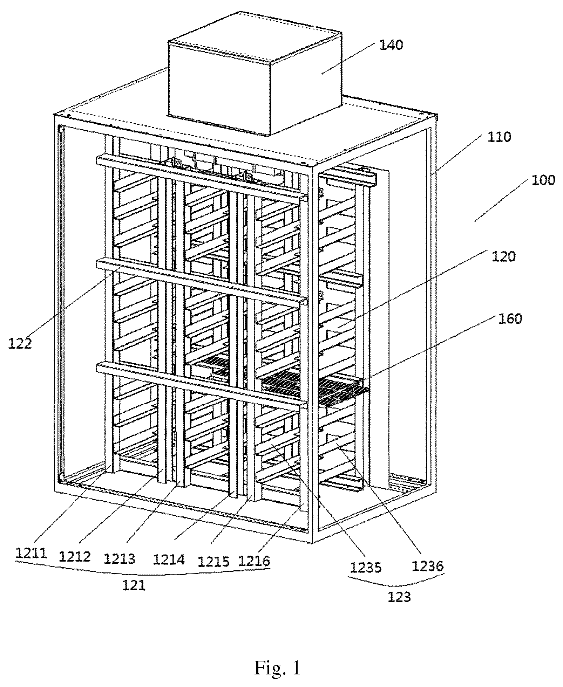

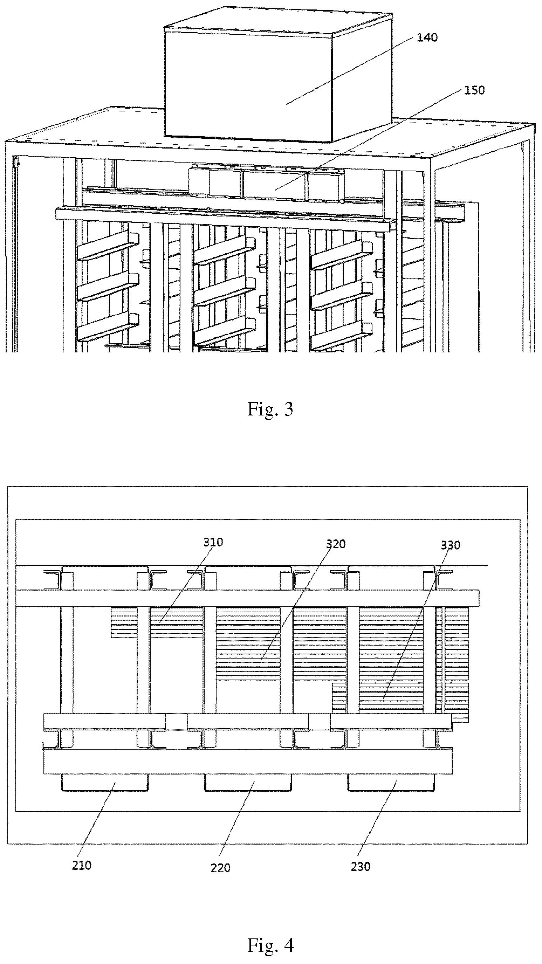

As shown in Fig. 1 to Fig. 4, the power cabinet 100 of present application includes a cabinet housing 110 and a rack 120 for supporting power modules. The housing 110 includes outer frame and panels on various sides, part of which are hided in Fig. 1 to show internal structure of the cabinet. Rack 120 includes six pairs (in total twelve) of upright beams 1211, 1212, 1213, 1214, 1215, 1216 (hereinafter collectively referred to as upright beam 121 unless otherwise mentioned) arranged in parallel, to form a space with three rows for accommodating power modules such as PEBB (referring to power modules 210, 220 and 230 in Fig. 4).

In order to mount power modules onto the rack and ease the removal of power module from the rack for repair or replacement without effecting other structures, the present application proposes to arrange the sliding rail 123 for supporting power modules on the paired upright beams 121, as shown in Fig. 1. For example, sliding rail 1236 is mounted on the rightmost paired upright beams 1216, while sliding rail 1235 is mounted on the paired upright beams 1215 which form a space with the paired upright beams 1216 to accommodate a column of power modules. Sliding rail 1235 and sliding rail 1236 are paired to be horizontally arranged so as to support a power module (not shown) thereon. By mounting a plurality of paired sliding rails 123, a plurality of power modules can be supported between the upright beams 121. For example, nine pairs of sliding rails can be mounted in the space between every two pairs of upright beams to support nine power modules, so the rack 120 can support in total twenty seven power modules in three columns. Certainly, it shall be understood that number of upright beams and row numbers of power modules can be decided by the power level of the converter and adjusted based on actual need. Further, although in the previous description the three rows of space for accommodating power modules are formed by six pairs of upright beams, it is also feasible to form the three rows of space by four pairs of upright beams, wherein the middle two pairs of beams can be commonly used. Furthermore, the present structure can also be applied where the three rows of space for accommodating power modules are formed by three pairs of upright beams, i.e. one sliding rail 123 is cantilevered on an upright beam instead of being supported by two beams from two ends. This structure is beneficial for small or light power modules.

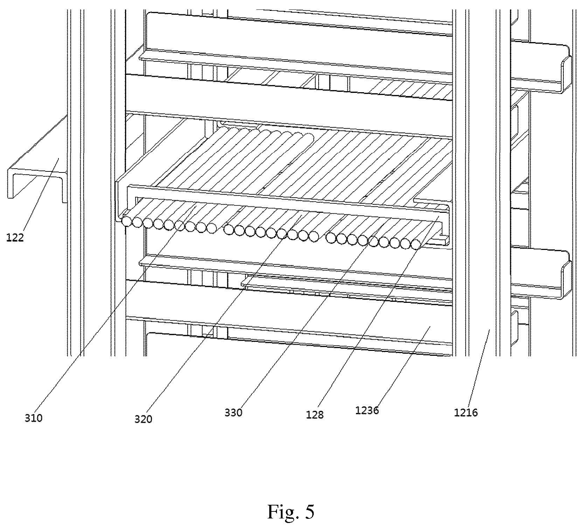

According to one embodiment of present application, horizontal beams 122 can be arranged on the rack with one or three power modules between two adjacent horizontal beams, amount of horizontal beams can be decided based on size of power module. Horizontal beams can be set at both front side and back side of the rack, to strength the rack and secure cable tray 128 (as shown in Fig. 5) thereon. In the embodiment shown in Fig. 1, in total six pairs (twelve) of horizontal beams 122 are arranged in the front and back, to form nine blocks with the six pairs of upright beams 121, with each row constituting one phase. Comparing with conventional structure, the present structure can reduce the size of converter, and miniaturize and compact the converter.

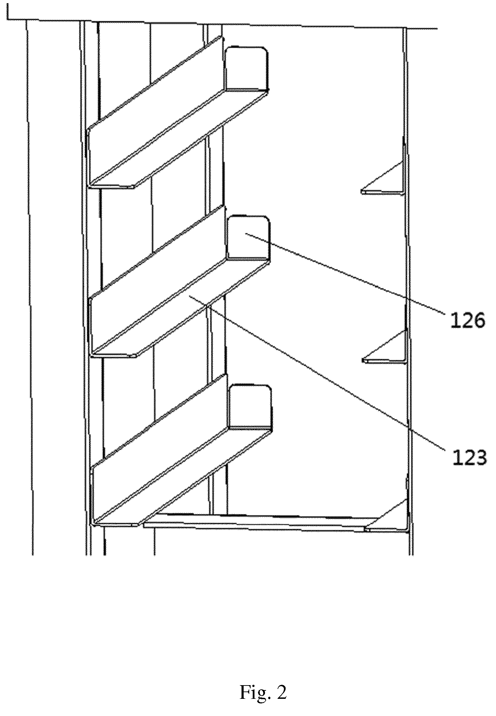

Fig. 2 shows a partially enlarged view of a power cabinet according to one embodiment of present application. Besides the above mentioned structure, Fig. 2 shows that a stopper 126 is provided at rear end of the sliding rail 123, to position respective power modules and ease the pull out and push in of the power module. It should be understood that stopper 126 can also be integrated with the sliding rail 123 rather than being separated.

Fig. 3 shows a partially enlarged view of a power cabinet according to one embodiment of present application. As shown in Fig. 3, a control distributor 150 is arranged in the power cabinet 100, for example at top middle of the power cabinet. Control distributor 150 is connected with various power modules through optical fiber, and is connected with the control cabinet through series communication interface. This structure can reduce the length of needed optical fiber, and make cable layout convenient, and is helpful for further compacting the power cabinet.

Fig. 4 shows a partial top view of a power cabinet according to one embodiment of present application. In the above mentioned power cabinet, power modules with same phase are connected in vertical direction through busbar (such as copper busbar or aluminum busbar), and connected with transformer cabinet through cables. To ease the cable layout and simplify assembling process, the present application proposes a stepwise layout as shown in Fig. 4 for the connection among power modules in same phase, i.e. cables 330, 320 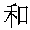 310, which are used to respectively connect three columns of power modules 230, 220 and 210 in same phase with transformer cabinet (on the right side of the power cabinet in Fig. 4, not shown), becomes longer from front to back of the power cabinet, so that there will be no interference when the power module is pulled out or pushed in. The structure can also make the layout neat instead of being messy like in the existing design. As shown in Fig. 1, a bracket 160 can be provided on the rack 120 at the side close to the transformer cabinet, to support and secure cables 330, 320 and 310.

Fig. 5 shows a partially enlarged side view of a power cabinet according to one embodiment of present application. As shown in Fig. 5, cable tray 128 can be provided between respective paired horizontal beams to support cables passing through the power cabinet. It can make cable layout neat and improve the safety level of the whole equipment. Specific amount and position of the cable tray 128 can be adjusted based on actual need, and it will not be further described here.

Further, as shown in Fig. 1 and Fig. 3, a cooling fan 140 is provided on the top of the power cabinet, such as on the top of the housing of the power cabinet, to form an air path together with other inlets so as to cool power modules. Specific amount and position of the cooling fan can be adjusted based on actual need.

Though the present invention has been described on the basis of some preferred embodiments, those skilled in the art should appreciate that those embodiments should by no way limit the scope of the present invention. Without departing from the spirit and concept of the present invention, any variations and modifications to the embodiments should be within the apprehension of those with ordinary knowledge and skills in the art, and therefore fall in the scope of the present invention which is defined by the accompanied claims.

## Claims

1. A power cabinet for MV/HV converter, **characterized in that**, the power cabinet including a cabinet housing (100) and a rack (120) for mounting power modules, the rack (120) including at least a pair of upright beams (121) and sliding rails (123) arranged on the paired upright beams, the at least a pair of upright beams form at least a column of space for accommodating power modules, and the sliding rails are used for supporting the power modules.

2. The power cabinet according to claim 1, **characterized in that**, the rack further includes a plurality of horizontal beams (122) arranged in the width direction of the power cabinet.

3. The power cabinet according to claim 2, **characterized in that**, the plurality of horizontal beams (122) are arranged with one or three power modules therebetween.

4. The power cabinet according to claim 2, **characterized in that**, a cable tray (128) is arranged on the horizontal beam(122).

5. The power cabinet according to claim 4, **characterized in that**, the rack (120) is divided into three rows by the horizontal beam.

6. The power cabinet according to any one of claim 1 to claim 5, **characterized in that**, the power cabinet is provided with a control distributor (150).

7. The power cabinet according to claim 6, **characterized in that**, cables used for power modules with same phase becomes longer from front to back of the cabinet.

8. The power cabinet according to claim 7, **characterized in that**, a cooling fan (140) is provided on the top of the housing.

9. The power cabinet according to claim 8, **characterized in that**, a stopper (126) is provided at rear end of the sliding rail.
